# EUROPEAN PATENT APPLICATION

(11) **EP 1 655 708 A1**
(43) Date of publication of application: **10.05.2006**
(21) Application number: 04771592.5
(22) Date of filing: 12.08.2004
(51) Int. Cl.: G09F 9/30, H05B 33/02, H05B 33/14

(54) **DISPLAY**

(30) Priority: 13.08.2003 JP 2003293113
(71) Applicant: Toshiba Matsushita Display Technology Co., Ltd., Minato-ku, Tokyo 108-0075 (JP); KABUSHIKI KAISHA TOSHIBA, Tokyo 105-8001 (JP)
(72) Inventor: UEMURA, Tsuyoshi, (JP); OKUTANI, Satoshi, (JP); KUBOTA, Hirofumi, (JP); OKADA, Naotada, (JP); TONOTANI, Junichi, (JP)
(74) Representative: HOFFMANN EITLE
(86) International application number: PCT/JP2004/011617
(87) International publication number: WO 2005/017862

(57) **Abstract**

Provided is a display (1) including pixels each of which contains a light emitting element (40) and which are arranged in a matrix form, a light transmitting insulating layer (10) which includes a back surface facing the light emitting element (40) and a front surface as a light output surface, a beam-condensing element (30) which is arranged on a back side of the insulating layer (10) and increases a directivity of light emitted by the light emitting element (40) to make the light incident on the insulating layer (10), and a diffusing element (60) which is arranged on a front side of the insulating layer (10), diffuses light from the insulating layer (10), and output the diffused light to an external environment.

## Description

### Technical Field

The present invention relates to a display which includes a light emitting element such as an organic EL (electroluminescent) element.

### Background Art

Since organic EL displays are of self-emission type, they have a wide viewing angle and a high response speed. Further, they do not require a backlight, and therefore, low profile and light weight are possible. For these reasons, the organic EL displays are attracting attention as a display which substitutes the liquid crystal display.

An organic EL element, which is the main part of the organic EL displays, includes a light transmitting front electrode, a light reflecting or light transmitting back electrode facing the front electrode, and an organic layer interposed between the electrodes and containing a light emitting layer. The organic EL element is a charge-injection type light emitting element which emits light when an electric current flows through the organic layer.

In order to display an image on an organic EL display, it is necessary that light emitted from its emitting layer be output from the front electrode. However, of the light travels toward the front side in the element, the portion which travels in a wide-angle direction is totally reflected on the interface of the front electrode. For this reason, a great portion of the light emitted by the organic layer cannot go out of the organic EL element.

As illustrated with the organic EL display, displays in which each pixel has a light emitting element entail the drawback in which the outcoupling efficiency of the light emitting element is not sufficient. In addition, the inventors of the present invention, during the course of achieving the present invention, have found that the luminous efficiency of such a display is greatly influenced by not only the outcoupling efficiency of the light emitting element, but also other factors.

### Disclosure of Invention

It is an object of the present invention to increase the luminous efficiency of a display which includes an emitting element such as organic EL element.

According to the first aspect of the present invention, there is provided a display comprising pixels each of which contains a light emitting element and which are arranged in a matrix form, a light transmitting insulating layer which comprises a back surface facing the light emitting element and a front surface as a light output surface, a beam-condensing element which is disposed on a back side of the insulating layer and increases a directivity of light emitted by the light emitting element to make the light incident on the insulating layer, and a diffusing element which is disposed on a front side of the insulating layer, diffuses light from the insulating layer, and output the diffused light to an external environment.

According to the second aspect of the present invention, there is provided a display comprising pixels each of which contains a light emitting element and which are arranged in a matrix form, a light transmitting insulating layer which comprises a back surface facing the light emitting element and a front surface as a light output surface, a beam-condensing element which is disposed on a back side of the insulating layer and converges light emitted by the light emitting element to make the light incident on the insulating layer, and a diffusing element which is disposed on a front side of the insulating layer, diffuses light from the insulating layer, and output the diffused light to an external environment.

According to the third aspect of the present invention, there is provided a display comprising a light emitting element which comprises a front electrode, a back electrode facing the front electrode, and a photo-active layer interposed between the front and back electrodes and including an emitting layer, a light transmitting insulating layer which comprises a back surface facing the front electrode and a front surface as a light output surface, a beam-condensing element which is disposed on a back side of the insulating layer and increases a directivity of light emitted by the light emitting element to make the light incident on the insulating layer, and a diffusing element which is disposed on a front side of the insulating layer, diffuses light from the insulating layer, and output the diffused light to an external environment.

According to the fourth aspect of the present invention, there is provided a display comprising a light emitting element which comprises a front electrode, a back electrode facing the front electrode, and a photo-active layer interposed between the front and back electrodes and including an emitting layer, a light transmitting insulating layer which comprises a back surface facing the front electrode and a front surface as a light output surface, a beam-condensing element which is disposed on a back side of the insulating layer and converges light emitted by the light emitting element to make the light incident on the insulating layer, and a diffusing element which is disposed on a front side of the insulating layer, diffuses light from the insulating layer, and output the diffused light to an external environment.

According to the fifth aspect of the present invention, there is provided a display comprising pixels each of which includes a light emitting element and a pixel switch and which is arranged in a matrix form, a diffusing element which is disposed on a front side of the light emitting element, diffuses input light, and output the diffused light, and a beam-condensing element which is disposed between the light emitting element and the diffusing element and increases a directivity of light emitted by the light emitting element to make the light incident on the insulating layer.

### Brief Description of Drawings

FIG. 1 is a plan view schematically showing a portion of an organic EL display according to the first embodiment of the present invention;
FIG. 2 is a cross sectional view schematically showing the organic EL display shown in FIG. 1;
FIG. 3 is a graph illustrating the relationship between the grating constant of the diffraction grating and the incident angle of the first-order diffracted light on an interface between a transparent substrate and an external environment, in the organic EL display shown in FIG. 2; and
FIG. 4 is a cross sectional view schematically showing a portion of an organic EL display according to the second embodiment of the present invention.

### Best Mode for Carrying Out the Invention

Embodiments of the present invention will now be described with reference to accompanying drawings. The organic EL display will be described as an example of the display which includes a light emitting element. Throughout the drawings, structural elements which have similar or analogous functions are designated by the same reference symbols, and a repetitive explanation thereof will be omitted.

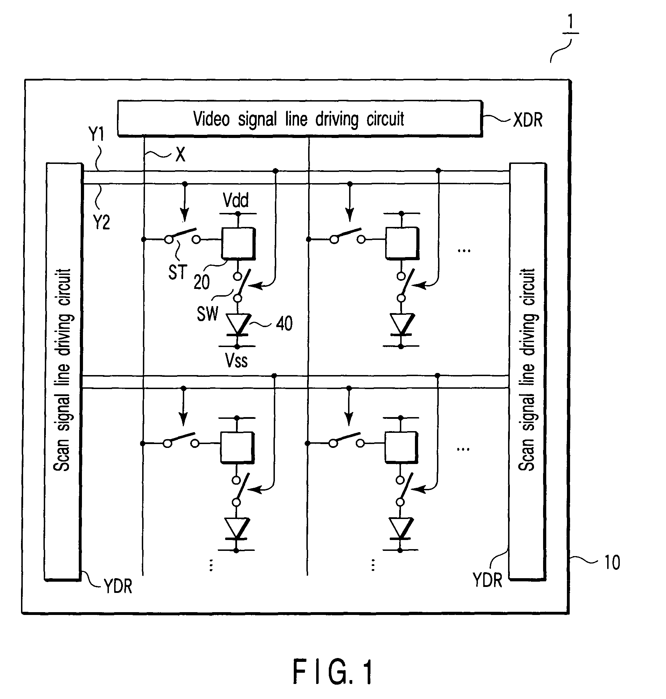

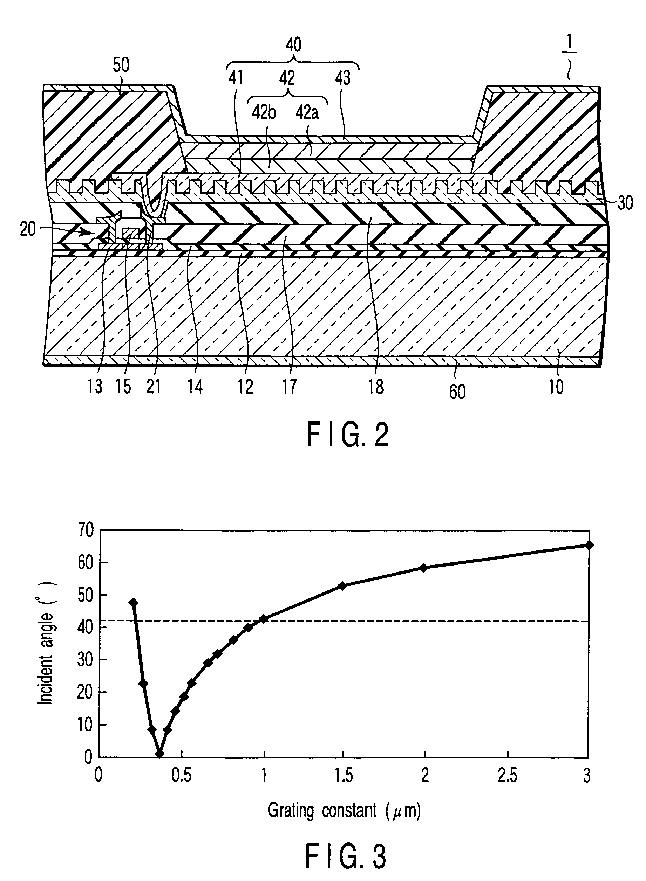

FIG. 1 is a plan view schematically showing a part of an organic EL display according to the first embodiment of the present invention. FIG. 2 shows a cross sectional view schematically showing the organic EL display shown in FIG. 1. In FIG. 2, the organic EL display 1 is illustrated such that its display surface, that is, the front surface, faces downward and the back surface faces upward.

The organic EL display 1 is a bottom emission type organic EL display which employs an active matrix drive method. The organic EL display 1 includes a transparent substrate 10 such as a glass substrate as an insulating layer with light transmission property.

On the transparent substrate 10, pixels are arranged in a matrix form. Each pixel includes, for example, an element control circuit 20, an output switch SW, an organic EL element 40, which are connected in series between a pair of power source terminals Vdd and Vss, and a pixel switch ST. The control terminal of the element control circuit 20 is connected to a video signal line (not shown) via the pixel switch. The element control circuit 20 outputs a current, which has a magnitude corresponding to a video signal supplied from the video signal line driving circuit XDR through the video signal line X and the pixel switch ST to the organic EL element 40. The control terminal of the pixel switch ST is connected to a scan signal line Y2, and the ON/OFF operation thereof is controlled in accordance with a scan signal supplied from the scan signal line driving circuit YDR through the scan signal line Y2. The control terminal of the output control switch SW is connected to a scan signal line Y1, and the ON/OFF operation thereof is controlled in accordance with a scan signal supplied from the scan signal line driving circuit YDR through the scan signal line Y1. Note that other structures can be employed for the pixels.

On the substrate 10, as an undercoat layer 12, for example, an SiNₓ layer and an SiOₓ layer are arranged in this order. A semiconductor layer 13 such as a polysilicon layer in which a channel, source and drain are formed, a gate insulator 14 which can be formed with use of, for example, TEOS (tetraethyel orthosilicate), and a gate electrode 15 made of, for example, MoW, are arranged in this order on the undercoat layer 12, and these layers form a top gate-type thin film transistor (referred to as a TFT hereinafter). In this example, the TFTs are used as TFTs of the pixel switch ST, output switch SW and element control circuit 20. Further, on the gate insulator 14, scan signal lines (not shown) which can be formed in the same step as that for the gate electrode 15 are arranged.

An interlayer insulating film 17 made of, for example, SiOₓ which is deposited by a plasma CVD method, is arranged on the gate insulator 14 and gate electrode 15. Source and drain electrodes 21 are arranged on the interlayer insulating film 17, and they are buried in a passivation film 18 made of, for example, SiNₓ. The source and drain electrodes 21 have a three-layer structure of, for example, Mo/Al/Mo, and electrically connected to the source and drain of the TFT via a contact hole formed in the interlayer insulating film 17. Further, on the interlayer insulating film 17, video signal lines X which can be formed in the same step as that for the source and drain electrodes 21 are arranged.

A beam-condensing element is arranged on the passivation film 18. As an example, a diffraction grating 30 is used as the beam-condensing element. Further, as a example, the diffraction grating 30 used here has a structure in which a predetermined pattern of recess is formed on the surface on the side of the first waveguide, that is, the surface which is in contact with the organic EL element 40, and it is made of a material having optical properties different from those of the first waveguide layer. For the beam-condensing element 30, an organic insulating material such as resist or polyimide can be used. The pattern formed on the surface of the diffraction grating 30 can be designed in various ways including stripes and lattices. Alternatively, the diffraction grating 30 used here may have a structure in which though holes or recesses are formed in the insulating layer. For example, it may have a structure including a first portion in which though holes or recesses are formed and a second portion which fills the recesses or through holes formed in the first portion and differs in optical properties from the first portion 31. Through holes which communicate with the drain electrodes 21 are formed in the passivation film 18 and the beam-condensing element 30.

Front electrodes 41 with light transmission property are juxtaposed on the diffraction grating 30 and spaced apart from one another. In this example, the front electrodes 41 are anodes and are made of, for example, a transparent conductive oxide such as ITO (indium tin oxide). Each front electrode 41 is electrically connected to the drain electrode 21 via a through hole formed in the passivation film 18 and the diffraction grating 30.

Further, a partition insulating layer 50 is arranged on the diffraction grating 30. The partition insulating layer 50 is provided with through holes at positions corresponding to the front electrodes 41. The partition insulating layer 50 is, for example, an organic insulating layer, and can be formed with use of a photolithography technique.

On the portion of the front electrode 41 which is exposed to the inside of the through hole of the partition insulating layer 50, an organic layer 42 which includes a light emitting layer 42a is arranged. The emitting layer 42a is a thin film containing a luminescent organic compound which can generate a color of, for example, red, green or blue. The organic layer 42 can further contain layers other than the light emitting layer 42a. For example, the organic layer 42 can further contain a buffer layer 42b which serves to mediate the injection of positive holes from the front electrode 41 into the emitting layer 42a. The organic layer 42 can further contain a hole transporting layer, a hole blocking layer, an electron transporting layer, an electron injection layer, etc.

A back electrode 43 with light-reflection property is arranged on the partition insulating layer 50 and organic layer 42. In this example, the back electrode 43 is a cathode which is continuously formed and common to all pixels. The back electrode 43 is electrically connected to the electrode wiring, the electrode wiring being formed on the layer on which video signal lines X are formed, via a contact hole (not shown) formed in the passivation film 18, the beam-condensing element 30 and the partition insulating layer 50. Each organic EL element 40 includes the front electrode 41, organic layer 42 and back electrode 43.

Note that the organic EL display 1 shown in FIG. 2 usually further includes a sealing substrate facing the back electrode 43, and a sealing layer (not shown) formed along the periphery of the surface of the sealing substrate which faces back electrode 43, and with this structure, an enclosed space is formed between the back electrode 43 and sealing substrate. This space can be filled with, for example, a noble gas such as Ar gas or an inert gas such as N₂ gas.

The organic EL display 1 further includes a diffusing element on an outer side of the transparent substrate 10, that is, on the front side. Here, as an example, a light-scattering layer 60 is used as the diffusing element.

A polarizer may be arranged between the transparent substrate 10 and the light-scattering layer 60. An ND (neutral density) filter may be arranged on the light scattering layer 60.

The present inventors conducted intensive researches to increase the luminous efficiency of organic EL displays, and have found the following facts.

The luminous efficiency of an organic EL display is greatly influenced not only by the outcoupling efficiency of the organic EL element, but also by some other factors. More specifically, even if light can be output from an organic EL element at a high efficiency, the luminous efficiency of the organic EL display cannot be increased to a sufficient level as long as light cannot be output at a high efficiency from a light transmitting insulating layer arranged on the front side of the organic EL element. In other words, in order to increase the luminous efficiency of the organic EL display, it is necessary to sufficiently prevent the light incident on the light transmitting insulating layer from being totally reflected on an interface between the light transmitting insulating layer and an external environment, typically the atmosphere. That is, it is important to suppress that the light output from the first waveguide layer, which is the laminate of the front electrode 41 and organic layer 42 in this example, and entered into the second waveguide layer, which is a light transmitting insulating layer such as the substrate 10 in this example, is totally reflected by the light outputting surface of the second waveguide layer.

According to the researches made by the present inventors, it has been found that in order to sufficiently prevent the light entered into the light transmitting insulating layer from being totally reflected by the interface between the light transmitting insulating layer and the external environment, the light should be made incident on the light transmitting insulating layer at an angle equal to or smaller than the critical angle at the interface between the light transmitting insulating layer and the external environment, and the directivity of the light should be extremely high. More specifically, the directivity of the light should be enhanced to such a level that the use of the light scattering layer becomes necessary in order to achieve a sufficient viewing angle. In order to enhance the directivity of the light incident on the light transmitting insulating layer with use of a diffraction grating, it is necessary to set the grating constant to a very small value.

Note that the emitting layer of the organic EL element emits light in all directions. Therefore, it is originally not necessary to arrange a light scattering layer to achieve a wide viewing angle in organic EL displays. Based on such a background, the conventional organic EL displays do not use a light scattering layer or output light with a high directivity from a light transmitting insulating layer arranged on an observer side with regard to the organic EL element.

Further, the present inventors have found that multiple reflection and multiple interference, that is, "multiple-beam interference" need be considered. The "multiple-beam interference" is an interference which occurs as some of light rays are repeatedly reflected between reflecting surfaces, that is, parallel plane-like reflecting surfaces.

Multiple-beam interference occurs in a very thin layer such as the laminate of the front electrode 41 and organic layer 42. Of the light which travels within the laminate, a light beam which travels in a certain direction is enhanced, whereas a light beam which travels in another direction is weakened. In other words, the traveling direction of the light which propagates in an in-plane direction while repeatedly reflected between both main surfaces of the laminate is regulated. Therefore, of the lights which propagate in the in-plane direction while repeatedly reflected in the above described laminate, the light with the maximum intensity is particularly.important to effectively utilize in order to improve the luminous efficiency of the organic EL display.

FIG. 3 is a graph showing the relationship between the grating constant of a diffraction grating 30 and the incident angle of the first-order diffracted light on an interface between a transparent substrate 10 and an external environment obtained in the organic EL display shown in FIG. 1. In this figure, the abscissa represents the grating constant of the diffraction grating 30, whereas the coordinate represents the incident angle of the first-order diffracted light incident on the interface between the transparent substrate 10 and the external environment.

The data shown in FIG. 3 are obtained by performing a simulation under the following conditions. That is, in this simulation, the thickness of the laminate of the front electrode 41 and organic layer 42 was set to 150 nm, and the refractive index of the laminate was set to 1.55. Further, the organic layer 42 was of a type which emits light having a wavelength of 530 nm. Furthermore, a glass substrate was used as the transparent substrate 10, and the critical angle for the light which travels toward the external environment (the atmosphere) from the inside of the transparent substrate 10 was set to 41.3°.

Moreover, the multiple-beam interference in the laminate of the front electrode 41 and the organic layer 42 is considered, and, of the lights which propagate in the in-plane direction in the laminate, the light with the maximum intensity was used to calculate the diffraction by the diffraction grating 30. More specifically, based on the wavelength, thickness and refractive index of the laminate, of the lights which propagate in the in-plane direction in the laminate, the light with the maximum intensity was supposed to travel in a direction which made an angle of 63.7° with respect to the film surface, and the diffraction of the light by the diffraction grating 30 was calculated. Further, since the traveling direction of the 0-order diffracted light was not changed and the diffracted light of a higher order than that of the first-order diffracted light was very weak, only the first-order diffracted light was considered here.

As shown in FIG. 3, in the case where the grating constant is greater than about 1 *µ*m, the incident angle of the first-order diffracted light against the interface between the transparent substrate 10 and the external environment is equal to or greater than the critical angle. Therefore, in this case, the first-order diffracted light cannot be utilized for display.

In the case where the grating constant is in a range from about 1 µm to about 0.2 *µ*m, the incident angle of the first-order diffracted light against the interface between the transparent substrate 10 and the external environment is smaller than the critical angle. In particular, when the grating constant is set in a range larger than 0.2 *µ*m and less than 0.4 *µ*m, the incident angle can be reduced to an extremely small value. When the grating constant is set to about 0.35 *µ*m, the incident angle can be set to 0° .

Note that, in the case where the grating constant is less than about 0.2 *µ*m, the incident angle of the first-order diffracted light against the interface between the transparent substrate 10 and the external environment is equal to or greater than the critical angle. Therefore, in this case, the first-order diffracted light cannot be utilized for display.

As described, in the case where the grating constant of the diffraction grating is very small, the incident angle of the first-order diffracted light against the interface between the transparent substrate 10 and the external environment can be made extremely small. In this case, of the lights which propagate in the film surface direction in the laminate, not only the light with the maximum intensity but also most of the lights with a lower intensity can have an incident angle smaller than the critical angle. Therefore, a great portion of the lights incident on the transparent substrate 10, which is a light transmitting insulating layer, can be output to the external environment. In other words, according to the organic EL display, a high luminous efficiency can be realized.

With this technique, the directivity of the light output from the transparent substrate 10 is significantly enhanced as described above. The directivity of the light can be freely changed with use of the light scattering layer 60 in accordance with the usage of the organic EL display 1. For example, in the case where the organic EL display 1 is used in a mobile device such as a mobile telephone, the organic EL display 1 is not required to have a wide viewing angle, but it requires to have a bright display or a low power consumption. Therefore, for this particular usage, a light scattering layer 60 which has a low light scattering capability may be used. On the other hand, in the case where the organic EL display 1 is utilized as a display for a stationary device, the organic EL display 1 is required to have a wide viewing angle. Therefore, for this particular usage, a light scattering layer 60 which has a high light scattering capability may be used.

As described above, by outputting light having a directivity in a certain direction and adjusting the directivity with the light scattering layer 60 in accordance with the usage of the element, the output light can be utilized more efficiently and therefore the luminous efficiency can be further improved.

Next, the second embodiment of the present invention will be described.

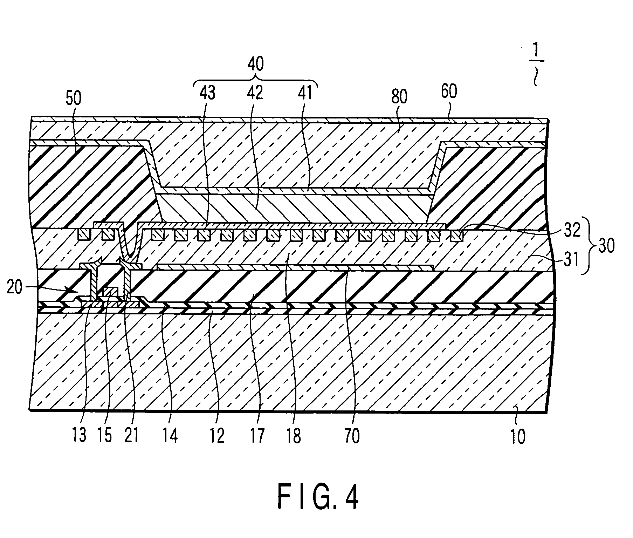

FIG. 4 is a plan view schematically showing the organic EL display according to the second embodiment of the present invention. In FIG. 4, the organic EL display 1 is illustrated such that its front surface faces upward and the back surface faces downward.

The organic EL display 1 is a top emission type organic EL display. Therefore, unlike the first embodiment, the substrate 10 need not have a light transmission property.

As in the case of the first embodiment, an undercoat layer 12, TFTs, an interlayer insulating film 17 and a passivation film 18 are formed in this order. Contact holes are formed in a gate insulator 14, the interlayer insulating film 17 and the passivation film 18, and source and drain electrodes 21 are electrically connected to the source and drain of the TFT via the contact hole.

On the interlayer insulating film 17, a reflection layer 70 and a first portion 31 of a diffraction grating 30 are arranged in this order In this example, the first portion 31 is formed to be integrated with the passivation film. As the material of the reflecting layer 70, for example, a metal material such as A1 can be used. Here, the reflection layer 70 has a three-layer structure of Mo/Al/Mo so that it can be formed in the same step as that for the source and drain electrodes. Further, as the material of the first portion 31, for example, an insulating material such as SiN can be used.

Recesses of the first portion are filled with a second portion 32 made of a light transmitting insulating material having a refractive index.different from that of the first portion 31, such as a resist material. In other words, with this structure, the refractive index varies from the first portion 31 to the second portion 32 at the interface between them as a border, and further a regular pattern is formed on the interface.

Back electrodes 43 with light transmission property are arranged on the diffraction grating 30 and are spaced apart from one another. In this example, each back electrode 43 is an anode and is made of a transparent insulating oxide such as ITO.

A partition insulating layer 50 similar to that described in the first embodiment is formed on the first portion 31 of the diffraction grating 30. On the portion of the back electrode 43 which is exposed to a space in a through hole of the partition insulating layer 50, an organic layer 42 which includes a light emitting layer 42a is arranged as in the first embodiment.

A front electrode 41 with light-transmission property is arranged on the partition insulating layer 50 and organic layer 42. In this example, the front electrode 41 is a cathode which is continuously formed and common to all pixels.

A transparent protective film 80 which is a light transmitting insulating layer and a light scattering layer 60 are arranged in this order on the front electrode 41. The transparent protective layer 80 inhibits, for example, the enter of moisture from the external environment into the organic EL element 40 and serves as a flattening layer. As the material of the transparent protective layer 80, a transparent resin can be used. Further, the transparent protective layer 80 may employ a single layer structure or multi-layer structure.

A polarizer may be arranged between the transparent protective layer 80 and the light-scattering layer 60. Further, an ND filter may be arranged on the light scattering layer 60.

In the first embodiment, the diffraction grating 30 is arranged between the organic EL element 40 and the transparent substrate 10 which is a light transmitting insulating layer, that is, on the front side of the organic EL element 40. In contrast, in the second embodiment, the diffraction grating 30 is arranged between the organic EL element 40 and the reflecting layer 70, that is, on the back side of the organic EL element 40. Even with this structure employed in the second embodiment, substantially the same effect as that of the first embodiment can be obtained.

It should be noted that when the diffraction grating 30 is arranged on the back side of the organic EL element 40, a portion of the light emitted by the organic EL element 4 is made incident on the light transmitting insulating layer without passing through the diffraction grating 30. Therefore, in order to diffract more light beams, it is more advantageous that the diffraction grating 30 should be arranged between the organic EL element 40 and the light transmitting insulating layer.

In the first and second embodiments, the arrangement of the structural elements of the organic EL display 1 can be varied in many ways. For example, in the organic EL display 1 shown in FIG. 2, the diffraction grating 30 may be arranged between the interlayer insulating film 17 and the passivation film 18. Alternatively, in the organic EL display 1 shown in FIG. 4, the reflection layer 70 may be arranged between the substrate 10 and the interlayer insulating film 17, and then the diffraction grating 30 may be arranged at the interface between the interlayer insulating film 17 and the passivation film 18.

In the first and second embodiments, as the diffraction grating 30, a one-dimensional lattice or a two-dimensional lattice may be used. In order to diffract more light, the latter is more advantageous.

In the first ands second embodiments, a transmission-grating was used. Alternatively, a reflection-grating may be used. For example, the diffraction grating 30 shown in FIG. 4 may be omitted and projections and recesses that form a diffraction grating may be formed on the front surface of the reflection layer 70.

In the case where the diffraction grating 30 includes the light transmitting first portion 31 and the second portions 32 which fill the recesses formed in the first portion, the optical properties of the second portion 32 should be different from those of the first portion 31 as described above. It suffices if the first portion 31 and second portions 32 are different in at least one of the refractive index, transmittance and reflectance. Typically, the second portions 32 should be made light transmitting and have a different refractive index from that of the first portion 31.

The bottom surface of the recess formed in the first portion 31 may be the surface of the first portion 31, or it may be the surface of the underlying layer of the first portion 31. Further, the organic EL display 1 shown in FIG. 2 can be regarded to have such a structure that the diffraction grating 30 serves as the first portion shown in FIG. 7 and a part of the electrode 41 serves as the second portions 32 shown in FIG. 7. The second portions 32, here, may be made of a material different from that of the electrode 41 or 43.

At least one of the first portion 31 and second portions 32 included in the diffraction grating 30 may have a higher refractive index as compared to that of a layer adjacent thereto on the side of the organic EL element 40. With this structure, the multiple-beam interference in the layer located on the side of the organic EL element 40 with respect to the diffraction grating 30 is promoted.

In the first and second embodiments, the surface or interface of the diffraction grating 30 is formed to have a rectangular cross section, but the surface or interface may be of some other shape. For example, the surface or interface of the diffraction grating 30 may have a sine wave-shaped cross section. In this case, diffraction light of a lower order can be easily generated as compared to the case of the rectangular cross section.

The width ratio of the recess and the projection formed in the first portion 31 may be about 1 : 1. In the case where the width ratio of the recess and the projection formed in the first portion 31 is set to 1 : 2, the second-order diffracted light with high intensity is generated, whereas in the case where the ratio is set to about 1 : 1, the first-order diffracted light with high intensity is generated.

In the first and second embodiments, the diffraction grating 30 is used as the beam-condensing element. Alternatively, some other optical element may be used. For example, in place of the diffraction grating 30, a lens array having a structure in which converging lenses are arranged may be used as the beam-condensing element.

In the first and second embodiments, the light scattering layer 60 is used as the diffusing element. Alternatively, the diffusing element may employ some other structure. For example, in the organic EL display shown in FIG. 2, a surface of the substrate 2 may be roughened so as to use the roughened surface as the light scattering surface. Alternatively, in the organic EL display shown in FIG. 2, a surface of the transparent protective film 80 may be roughened so as to use the roughened surface as the light scattering surface. Alternatively, the diffusing element may be the one which does not utilize light scattering. For example, in place of the light scattering layer 60, a lens array having a structure in which diverging lenses are arranged may be used as the diffusing element.

In the first and second embodiments, organic EL elements 40 which emit light of different colors are used and thus the organic EL display 1 employs a structure by which a full-color image can be displayed. Alternatively, the organic EL display 1 may employ a structure by which a monochromatic image can be displayed. A full-color image can be displayed even in the case where the organic EL display 1 employs some other structure. For example, in order to display the full-color image, organic EL elements 40 which emit light of white color and color filters may be used. Alternatively, in order to display the full-color image, organic EL elements 40 which emit light of blue color and a color conversion filter may be used. In the latter case, it is preferable that the diffraction grating 30 should be arranged between the organic EL element 40 and the color conversion filter. When the monochromatic light is diffracted, it is no longer necessary to consider the wavelength dependency of the diffraction grating 30. More specifically, optimization of the grating constant of the diffraction grating 30 may be performed only for the wavelength before color conversion, and it is not necessary to optimize the grating constant of the diffraction grating 30 for each and every color.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. A display comprising:
pixels each of which contains a light emitting element and which are arranged in a matrix form;
a light transmitting insulating layer which comprises a back surface facing the light emitting element and a front surface as a light output surface;
a beam-condensing element which is disposed on a back side of the insulating layer and increases a directivity of light emitted by the light emitting element to make the light incident on the insulating layer; and
a diffusing element which is disposed on a front side of the insulating layer, diffuses light from the insulating layer, and output the diffused light to an external environment.

2. A display comprising:
pixels each of which contains a light emitting element and which are arranged in a matrix form;
a light transmitting insulating layer which comprises a back surface facing the light emitting element and a front surface as a light output surface;
a beam-condensing element which is disposed on a back side of the insulating layer and converges light emitted by the light emitting element to make the light incident on the insulating layer; and
a diffusing element which is disposed on a front side of the insulating layer, diffuses light from the insulating layer, and output the diffused light to an external environment.

3. A display comprising:
a light emitting element which comprises a front electrode, a back electrode facing the front electrode, and a photo-active layer interposed between the front and back electrodes and including an emitting layer;
a light transmitting insulating layer which comprises a back surface facing the front electrode and a front surface as a light output surface;
a beam-condensing element which is disposed on a back side of the insulating layer and increases a directivity of light emitted by the light emitting element to make the light incident on the insulating layer; and
a diffusing element which is disposed on a front side of the insulating layer, diffuses light from the insulating layer, and output the diffused light to an external environment.

4. A display comprising:
a light emitting element which comprises a front electrode, a back electrode facing the front electrode, and a photo-active layer interposed between the front and back electrodes and including an emitting layer;
a light transmitting insulating layer which comprises a back surface facing the front electrode and a front surface as a light output surface;
a beam-condensing element which is disposed on a back side of the insulating layer and converges light emitted by the light emitting element to make the light incident on the insulating layer; and
a diffusing element which is disposed on a front side of the insulating layer, diffuses light from the insulating layer, and output the diffused light to an external environment.

5. The display according to any one of claims 1 to 4, wherein the light emitting element is an organic EL element.

6. The display according to any one of claims 1 to 4, wherein the beam-condensing element includes a diffraction grating.

7. The display according to any one of claims 1 to 4, wherein the diffusing element includes a light scattering surface.

8. The display according to any one of claims 1 to 4, wherein the beam-condensing element is disposed between the insulating layer and the front electrode.

9. The display according to any one of claims 1 to 4, further comprising a reflecting layer facing the back electrode, wherein the beam-condensing element is disposed between the insulating layer and the reflecting layer.

10. The display according to claim 9, wherein the beam-condensing element is disposed between the back electrode and the reflecting layer.

11. The display according to any one of claims 1 to 4, wherein the insulating layer includes a transparent substrate.

12. The display according to any one of claims 1 to 4, wherein the insulating layer includes a transparent protective layer.

13. The display according to claim 3 or 4, wherein the display is an active matrix display.

14. A display comprising:
pixels each of which includes a light emitting element and a pixel switch and which is arranged in a matrix form;
a diffusing element which is disposed on a front side of the light emitting element, diffuses input light, and output the diffused light; and
a beam-condensing element which is disposed between the light emitting element and the diffusing element and increases a directivity of light emitted by the light emitting element to make the light incident on the insulating layer.
